# EUROPEAN PATENT SPECIFICATION

(11) **EP 0 296 246 B1**
(45) Date of publication and mention of the grant of the patent: **28.07.1993**
(21) Application number: 87901668.1
(22) Date of filing: 04.03.1987
(51) Int. Cl.: H01L 23/02, H01L 23/04

(54) **SEMICONDUCTOR DEVICE AND METHOD OF FABRICATING THE SAME**
HALBLEITERANORDNUNG UND DEREN HERSTELLUNGSVERFAHREN
DISPOSITIF A SEMI-CONDUCTEUR ET PROCEDE DE FABRICATION

(30) Priority: 05.03.1986 JP 47792/86
(43) Date of publication of application: 28.12.1988
(73) Proprietor: Ceratec Japan Kabushiki Kaisha, Nagano 388 (JP)
(72) Inventor: HIRABAYASHI, Masaru, Nagano 388 (JP)
(74) Representative: Harrison, David Christopher
(86) International application number: JP8700139
(87) International publication number: WO8705442

(56) References cited:
- FR-A- 2 271 634
- JP-A- 6 079 749
- JP-A- 6 081 844
- JP-U- 5 532 005
- PATENT ABSTRACTS OF JAPAN, vol. 9, no. 225 (E-342)[1948], 11th September 1985; & JP-A-60 81 844

## Description

This invention relates to a method of making a package for a non-volatile IC memory device, having a window through which an ultraviolet ray or the like can be irradiated, and in another aspect to the package itself.

A semiconductor device having a non-volatile IC memory element, in which data already written can be erased and new data can be written, and housed in a semiconductor package, is generally known. A window is provided through which ultraviolet is irradiated onto the IC memory in the package of the device, and a window material such as glass is fitted in the window. The window has been provided in a circular or a rectangular shape.

For a window in a circular shape, the window material is easy to process. A semiconductor device having a circular window is shown in Fig. 4. A window hole is bored through the centre of an upper face of a semiconductor device 1, and a window material is fitted in the window hole to form a window 2 for irradiation. The window 2 is made of such a size that a non-volatile IC memory 3 can be seen therethrough.

In semiconductor devices having a large scale integrated non-volatile IC memory 3, however, the memory has a rectangular shape while the window 2 has a circular shape. The window 2 therefore needs to be made larger. This causes problems in that the width of the portion 4 between the edge of the window and the edge of the package becomes narrow, so that the package becomes weak.

Furthermore, the window material is heated to fix it in the window opening, with a possibility of making cracks in the portion 4 of the weakened semiconductor package owing to differences of expansion between the window material and the ceramic package material. Furthermore there is a possibility of distortion of the peripheral part of the window material while heating.

On the other hand, when the window 2 is made with a rectangular shape, there is a problem in that cracks develop easily at the corners of the window hole in the package. A window having corners of the window hole cut to form an octagon has been proposed to solve this problem, but its processing cost is high.

In Patent Abstracts of Japan, volume 9, No. 225(E-342)[1948], dated 11 September 1985, and in the corresponding JP-A-60/81844, there is described a cap for an EPROM device having a light-transmitting window in the shape of an elongate rectangle both ends of which are semicircular.

The object of the recent invention is to provide a method for making a package for a non-volatile IC memory device, which has a window through which an ultraviolet ray can be irradiated all over a non-volatile IC memory, and which can avoid weakness of the semiconductor package.

In one aspect the invention provides a method of making a package for a non-volatile IC memory device, in which a plate of window material is formed by slicing a rod of light-transmitting material and then fitted in a window hole cut through the package at a position registering with a non-volatile IC memory device position in the package,
characterised in that the rod which is sliced to form the plate of window material is a circular-section rod which is processed to form two opposing parallel side planes thereon, equally spaced from the rod axis, before the slicing.

In another aspect, the invention provides a package for a non-volatile IC memory device, having a plate of window material in a window opening formed in the package at a position in register with the position of said memory device therein, so that the memory device can be irradiated, the window opening and plate having opposed straight parallel side edges extending in the lengthwise direction of the package and opposed arcuate end edges extending across the package between the ends of the side edges,
characterised in that the arcuate end edges constitute segments of a single circle and the parallel side edges are chords of said circle.

### BRIEF DESCRIPTION OF THE DRAWINGS

A device manufactured according to an embodiment of the present invention is now described with reference to the accompanying drawings, in which:
Figure 1 is a plan view of a semiconductor device;
Figure 2 is an explanatory view showing the shape of a window of the device;
Figure 3 is a perspective view of a rod-shaped raw material for a glass window thereof, and
Figure 4 is a plan view of a conventional semiconductor device.

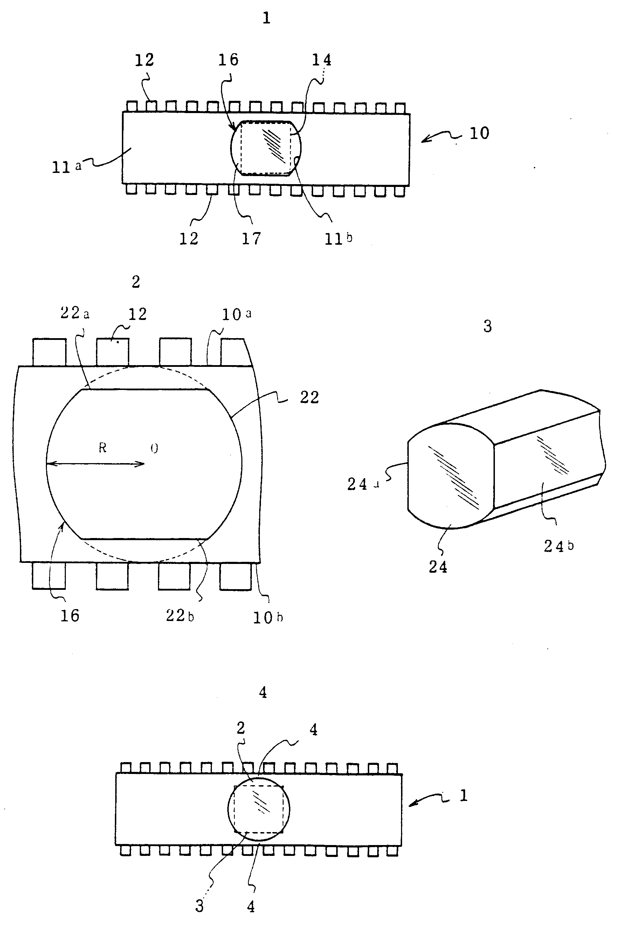

A preferred embodiment is described in detail with reference to the drawings. Figure 1 shows a plan view of the embodiment.

A semiconductor device indicated by 10 has a plurality of outer leads 12 extending from both its side faces, which extend in the lengthwise direction. A non-volatile IC memory 14 (shown in broken lines) is provided in the interior section of the semiconductor package 11a of the semiconductor device 10. The non-volatile IC memory is connected to inner leads by wires and to the outer leads by the inner leads.

A window 16 for irradiating an ultraviolet ray or the like is composed of a light-transmitting material 17 such as glass, fitted in a through-hole bored through the centre of the semiconductor package 11a. The end edges of the window 16, opposing each other in the lengthwise direction of the package, are arcuately formed while the side edges, opposing in the widthwise direction of the package, are straight and parallel.

Figure 2 is an explanatory view of the window.

The outer leads 12 extend from the side faces 10a,10b. Circle 22 is drawn around the point O with radius R. Chords 22a,22b are drawn straight and parallel to the side faces 10a,10b. The window 16 is formed in the area bounded by the circle 22 and the chords 22a,22b. In this case, the distances between each side face of the semiconductor package 11a and the respective chords 22a,22b are the same.

Next, the method of making the semiconductor device having the window for irradiation is described.

Conventionally, a circular window is formed by slicing a circular glass rod to give a plate.

In the present device, the window material 17 is formed by slicing a rod piece 24 having faces 24a,24b formed by cutting, parallel to one another. Figure 3 shows a perspective view of the rod piece 24. It is no more difficult than the conventional one.

As described above, the opposing edges at the sides of the window of the semiconductor package are formed straight and parallel, while the opposing edges at the ends are formed as arcs, so that the area of the window can be enlarged and a prescribed distance between the side edges (straight and parallel) and the sides of the semiconductor package can be achieved.

Therefore, in the present invention, weakening of the semiconductor package can be avoided even though a large window area is provided.

Furthermore, the window is not rectangular-shaped like some conventional ones, so that the possibility of developing cracks at the corners is avoided.

## Claims

1. A method of making a package (11a) for a non-volatile IC memory device (14), in which a plate of window material (17) is formed by slicing a rod of light-transmitting material and then fitted in a window hole (16) cut through the package (11a) at a position registering with a non-volatile IC memory device position in the package,
characterised in that
the rod which is sliced to form the plate of window material (17) is a circular-section rod (24) which is processed to form two opposing parallel side planes (24b) thereon, equally spaced from the rod axis, before the slicing.

2. A method according to claim 1 in which the rod (24) is of glass.

3. A package (11a) for a non-volatile IC memory device (14), having a plate of window material (17) in a window opening (16) formed in the package at a position in register with the position of said memory device therein, so that the memory device can be irradiated, the window opening (16) and plate (17) having opposed straight parallel side edges (22a,b) extending in the lengthwise direction of the package and opposed arcuate end edges (22) extending across the package between the ends of the side edges (22a,b),
characterised in that
the arcuate end edges (22) constitute segments of a single circle and the parallel side edges (22a,b) are chords of said circle.

4. A package according to claim 3 in which the side edges (22a,b) are equally spaced from the respective sides (10a,b) of the package.

## Patentansprüche

1. Verfahren zum Herstellen einer Kapselung (11a) für eine nichtflüchtige IC-Speichervorrichtung (14), bei dem eine Platte aus Fenstermaterial durch Schneiden einer Stange aus lichtdurchlässigem Material gebildet wird und dann in ein Fensterloch (16) eingepaßt wird, das durch die Kapselung (11a) an einer Position geschnitten ist, die sich in Übereinstimmung mit einer Position der nichtflüchtigen IC-Speichervorrichtung in der Kapselung befindet,
dadurch gekennzeichnet, daß die Stange, die zum Bilden der Platte des Fenstermaterials (17) geschnitten wird, eine Stange (24) mit kreisförmigem Querschnitt ist, die vor dem Schneiden zum Bilden zweier gegenüberliegender paralleler Seitenflächen (24b) darauf bearbeitet wird, die sich in gleichen Abständen von der Stangenachse befinden.

2. Verfahren nach Anspruch 1, bei dem die Stange (24) aus Glas ist.

3. Kapselung (11a) für eine nichtflüchtige IC-Speichervorrichtung (14) mit einer Platte aus Fenstermaterial (17) in einer Fensteröffnung (16), die einer Kapselung an einer Position in Übereinstimmung mit der Position der Halbleitervorrichtung darin gebildet ist, so daß die Halbleitervorrichtung bestrahlt werden kann, wobei die Fensteröffnung (16) und die Platte (17) gegenüberliegende gerade parallele Seitenkanten (22a, b), die sich in die Längsrichtung der Kapselung erstrecken und gegenüberliegende bogenförmige Endkanten (22), die sich quer über die Kapselung zwischen den Enden der Seitenkanten (22a, b) erstrecken, aufweisen,
dadurch gekennzeichnet,
daß die bogenförmigen Endkanten (22) Segmente eines einzigen Kreises darstellen und die parallelen Seitenkanten (22a, b) Sehnen des Kreises sind.

4. Kapselung nach Anspruch 3, bei der die Seitenkanten (22a, b) in gleichen Abständen von den entsprechenden Seiten (10a, b) der Kapselung angeordnet sind.

## Revendications

1. Procédé de fabrication d'un boîtier (11a) pour dispositif de mémoire rémanente (14) à circuits intégrés, dans lequel une plaque de matière (17) pour fenêtre est formée en découpant une tranche dans un barreau de matière transparente, puis est logée dans un trou (16) pour fenêtre ménagé à travers le boîtier (11a) à l'emplacement coïncidant avec l'emplacement d'un dispositif de mémoire rémanente à circuits intégrés placé dans le boîtier, caractérisé en ce que,
le barreau dans lequel une tranche est découpée pour former la plaque de matière (17) pour fenêtre est un barreau (24) de section circulaire qui est transformé pour former sur celui-ci, avant le prélèvement d'une tranche, deux plans latéraux parallèles opposés (24b), à égale distance de l'axe du barreau.

2. Procédé selon la revendication 1, dans lequel le barreau (24) est en verre.

3. Boîtier (11a) pour dispositif de mémoire rémanente (14) à circuits intégrés, ayant une plaque de matière (17) pour fenêtre dans une ouverture (16) pour fenêtre formée dans le boîtier à un emplacement coïncidant avec l'emplacement dudit dispositif de mémoire placé à l'intérieur de celui-ci, de façon que le dispositif de mémoire puisse être irradié, l'ouverture (16) pour fenêtre et la plaque (17) ayant des bords latéraux parallèles rectilignes opposés (22a,b) qui s'étendent dans le sens de la longueur du boîtier et des bords d'extrémités arqués opposés (22) qui s'étendent dans le sens de la largeur du boîtier entre les extrémités des bords latéraux (22a,b),
caractérisé en ce que
les bords d'extrémités arqués (22) constituent des segments d'un seul cercle et les bords latéraux parallèles (22a,b) sont des cordes d'arcs dudit cercle.

4. Boîtier selon la revendication 3, dans lequel les bords latéraux (22a,b) sont à égale distance des côtés respectifs (10a,b) du boîtier.
